# EUROPEAN PATENT SPECIFICATION

(11) **EP 2 030 237 B1**
(45) Date of publication and mention of the grant of the patent: **09.02.2011**
(21) Application number: 07809055.2
(22) Date of filing: 08.05.2007
(51) Int. Cl.: H01L 27/02

(54) **EFFICIENT TRANSISTOR STRUCTURE**
EFFIZIENTE TRANSISTORSTRUKTUR
STRUCTURE EFFICACE DE TRANSISTOR

(30) Priority: 08.05.2006 US 798568 P; 01.08.2006 US 821008 P; 23.08.2006 US 823332 P; 01.09.2006 US 824357 P; 13.09.2006 US 825517 P; 20.09.2006 US 524113; 25.10.2006 US 586467; 25.10.2006 US 586470; 25.10.2006 US 586471
(43) Date of publication of application: 04.03.2009
(73) Proprietor: Marvell World Trade Ltd., St. Michael 14027 (BB)
(72) Inventor: SUTARDJA, Sehat, Los Altos Hills, California 94022 (US)
(74) Representative: Grünecker, Kinkeldey, Stockmair & Schwanhäusser Anwaltssozietät
(86) International application number: PCT/US2007/011207
(87) International publication number: WO 2007/136556

(56) References cited:
- EP-A- 0 982 777
- EP-A- 1 420 450
- EP-A- 1 526 576
- EP-A- 1 548 831
- US-A- 4 409 499
- US-A- 5 444 275
- US-A- 5 793 068
- US-A- 5 838 050
- US-A1- 2003 209 759
- US-B1- 6 264 167
- US-B1- 6 404 013
- US-B1- 6 566 710

## Description

### FIELD OF THE INVENTION

The present invention relates to transistor structures, and more particularly to transistor structures with reduced chip area.

### BACKGROUND OF THE INVENTION

Integrated circuits or chips may include a large number of interconnected transistors. The transistors and other circuit elements are interconnected in various ways to provide desired circuit functions. It is usually most efficient to fabricate multiple integrated circuits on a single wafer. After processing, the integrated circuits that are fabricated on the wafer are separated and then packaged. The wafer can accommodate a fixed number of integrated circuits for a given integrated circuit size. Reducing the size of individual transistors in the integrated circuit may help to reduce the overall size of the integrated circuit. This, in turn, allows an increased number of integrated circuits or chips to be made on each wafer and reduces the cost of the integrated circuits.

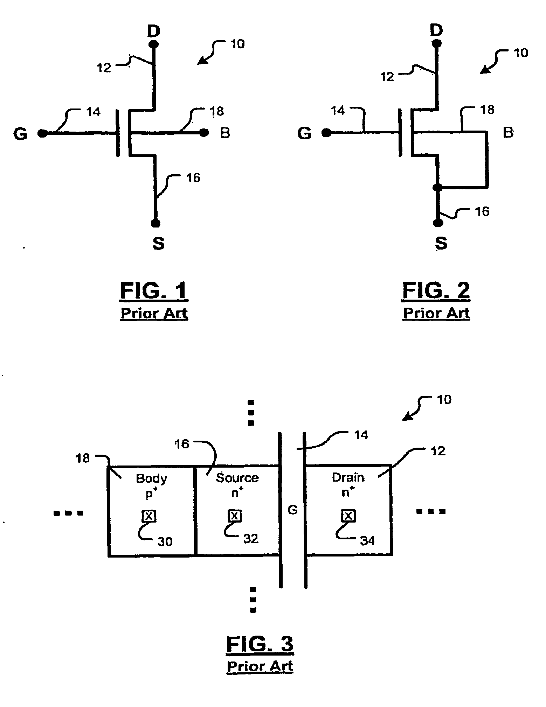

Referring now to FiGs. 1 and 2, an exemplary transistor 10 includes a drain 12, a gate 14, a source 16 and a body 18 or substrate tap. For example, the transistor 10 in FIG. 1 is an NMOS transistor. In some circumstances, the body 18 is connected to the source 16 as shown in FIG. 2.

Referring now to FIG. 3, the body 18 includes a p⁺ region and may include a contact tap 30. The source 16 includes an n⁺ region and may include a contact tap 32. The drain 12 includes an n⁺ region and may include a contact tap 34. Additional transistors may be fabricated on one or sides of the transistor 10 as indicated by "..." in FIG. 3.

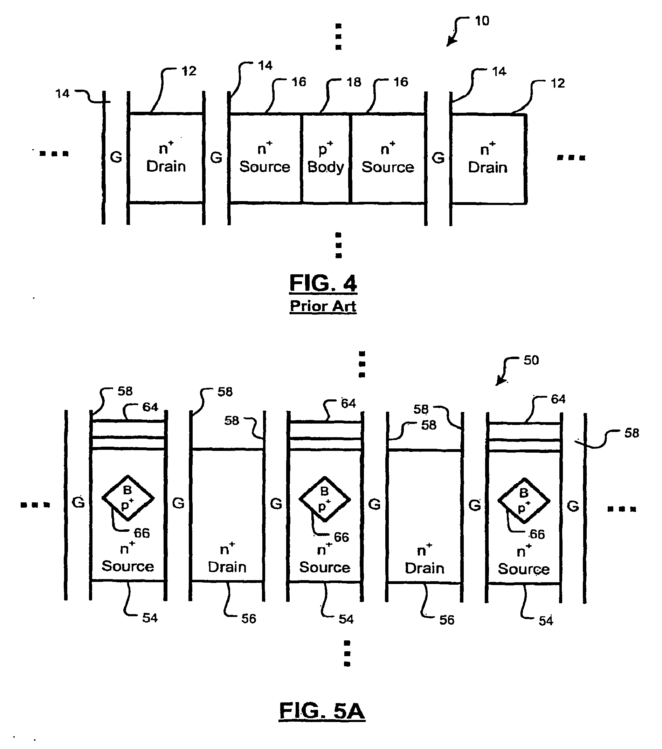

Referring now to FIG. 4, the body 18 may be repeated between sources 16 of adjacent transistors. The body 18 takes up valuable chip area and increases the size of the transistor and the integrated circuit. Additional transistors can be arranged on one or more sides of the transistor 10 as shown by "..." in FIG. 4.

EP 1 420 450 A2 relates to a semiconductor differential circuit used for a high-frequency circuit of a portable telephone, an oscillation apparatus, an amplifying apparatus and a switching apparatus using the semiconductor differential circuit. In one example, the semiconductor differential circuit has the drain electrode D1 and drain electrode D1' which are examples of rectangular first drain electrodes and the drain electrodes D2 and drain electrodes D2' which are examples of rectangular second drain electrodes. Further, it has the gate electrode G1 and gate electrodes G1' which are examples of the first gate electrodes and are placed to surround the drain electrodes D1 and D1' respectively. Gate electrode G2 and gate electrodes G2' which are examples of second gate electrodes are placed to surround the drain electrodes D2 and D2' respectively. A source electrode S1 in a longitudinal shape is placed between the gate electrode G1 and gate electrode G1' and between the gate electrode G2 and gate electrode G2'. A source electrode S2 in a longitudinal shape is connected to the source electrode S1 to cross it. This electrode is placed between the gate electrode G1 and gate electrode G2 and between the gate electrode G1' and gate electrode G2'. Further, a source electrode S3 is placed to surround the gate electrodes G1, G1', G2, G2' and the source electrodes S1 and S2. The source electrodes S1 and S2 are connected to the source electrode S3.

US 5,838,050 relates to a complementary metal oxide semiconductor (CMOS) device with a hexagonal device configuration. The CMOS hexagon device consists of four identical hexagon cells over a semiconductor substrate. That is, the four hexagon cells have the same size, shape and structure. Each hexagon cell has a hexagonal ring gate which includes a conducting portion and a dielectric layer deployed over the substrate. The conducting portion consists of conducting materials, such as polysilicon. The region enclosed by each hexagonal ring gate is a drain region. The drain regions are n-type diffusion regions if the substrate is a p-type substrate. A hexagon drain contact is formed over the centre of each drain region. Each ring gate is surrounded by a source region, which is an n-type diffusion region if the substrate is p-type. Through the charge induction by applying an electrical voltage on the conducting portion of the ring gate, a channel region can be formed under the ring gate in the substrate, thus electrically connecting the drain region and the source region.

### SUMMARY OF THE INVENTION

It is the object of the present invention to provide a low turn-on drain source resistance.

This object is solved by the subject matter of the independent claim.

Preferred embodiments are defined by the dependent claims.

An integrated circuit comprises a first source, a first drain, a second source, a first gate arranged between the first source and the first drain, and a second gate arranged between the first drain and the second source. The first and second gates define alternating first and second regions in the drain. The first and second gates are arranged farther apart in the first regions than in the second regions.

In other features, a well substrate contact is arranged in the first regions. Alternatively, R well substrate contacts are arranged in the first regions, where R is an integer greater than one. R is an integer that is greater than three and less than seven. The integrated circuit includes a plurality of transistors. The transistors include PMOS transistors. The R well substrate contacts are associated with respective ones of R transistors.

In other features, the integrated circuit comprises a second drain; and a third gate arranged between the second source and the second drain. The second and third gates define alternating third and fourth regions. The second and third gates are arranged farther apart in the third regions than in the fourth regions.

In yet other features, the first regions are arranged adjacent to the fourth regions and the second regions are arranged adjacent to the third regions. The first and third regions include R well substrate contacts.

A method for providing an integrated circuit comprises providing a first source; providing a first drain; providing a second source; locating a first gate between the first source and the first drain; locating a second gate between the first drain and the second source; defining alternating first and second regions in the drain using the first and second gates; and arranging the first and second gates farther apart in the first regions as compared to the second regions.

In other features, the method includes locating a well substrate contact in the first regions. The method includes locating R well substrate contacts in the first regions, where R is an integer greater than one. R is an integer that is greater than three and less than seven. The integrated circuit includes a plurality of transistors. The transistors include PMOS transistors. The method includes associating the R well substrate contacts with respective ones of R transistors.

In other features, the method includes providing a second drain; providing a third gate between the second source and the second drain; defining alternating third and fourth regions using the second and third gates; and arranging the second and third gates are arranged farther apart in the third regions than in the fourth regions.

In other features, the method includes arranging the first regions adjacent to the fourth regions and the second regions adjacent to the third regions. The first and third regions include R well substrate contacts, where R is an integer greater than one.

An integrated circuit comprises a first drain region having a generally rectangular shape. First, second, third and fourth source regions have a generally rectangular shape and are arranged adjacent to sides of the first drain region. A gate region is arranged between the first, second, third and fourth source regions and the first drain region. First, second, third and fourth substrate contact regions are arranged adjacent to corners of the first drain region.

In other features, the first, second, third and fourth source regions have a length that is substantially equal to a length of the drain region. The first, second, third and fourth source regions have a width that is less than a width of the first drain region. The width of the first, second, third and fourth source regions is approximately one-half the width of the first drain region.

In other features, a second drain region has a generally rectangular shape and has one side that is arranged adjacent to the first source region. Fifth, sixth and seventh source regions have a generally rectangular shape. The fifth, sixth and seventh source regions are arranged adjacent to other sides of the second drain region.

In other features, a gate region is arranged between the first, fifth, sixth and seventh source regions and the second drain region. Fifth and sixth substrate contact regions are arranged adjacent to corners of the second drain region. The integrated circuit includes laterally-diffused MOSFET transistors.

A method for providing an integrated circuit comprises providing a first drain region having a generally rectangular shape; arranging sides of first, second, third and fourth source regions, which have a generally rectangular shape, adjacent to sides of the first drain region; arranging a gate region between the first, second, third and fourth source regions and the first drain region; and arranging first, second, third and fourth substrate contact regions adjacent to corners of the first drain region.

In other features, the first, second, third and fourth source regions have a length that is substantially equal to a length of the drain region. The first, second, third and fourth source regions have a width that is less than a width of the first drain region. The width of the first, second, third and fourth source regions is approximately one-half the width of the first drain region.

In other features, the method includes arranging one side of a second drain region, which has a generally rectangular shape, adjacent to the first source region; and arranging fifth, sixth and seventh source regions, which have a generally rectangular shape, adjacent to other sides of the second drain region. The method includes arranging a gate region between the first, fifth, sixth and seventh source regions and the second drain region. The method includes arranging fifth and sixth substrate contact regions adjacent to corners of the second drain region. The integrated circuit includes laterally-diffused MOSFET transistors.

An integrated circuit comprises a first drain region having a symmetric shape across at least one of horizontal and vertical centerlines. A first gate region has a first shape that surrounds the first drain region. A second drain region has the symmetric shape. A second gate region has the first shape that surrounds the second drain region. A connecting gate region connects the first and second gate regions. A first source region is arranged adjacent to and on one side of the first gate region, the second gate region and the connecting gate region. A second source region is arranged adjacent to and on one side of side of the first gate region, the second gate region and the connecting gate region.

In other features, the symmetric shape tapers as a distance from a center of the symmetric shape increases. First and second substrate contacts are arranged in the first and second source regions. The integrated circuit includes laterally-diffused MOSFET transistors.

In other features, the symmetric shape is a circular shape. The symmetric shape is an elliptical shape. The symmetric shape is a polygonal shape. The symmetric shape is a hexagonal shape.

A method for providing an integrated circuit comprises providing a first drain region having a symmetric shape across at least one of horizontal and vertical centerlines; providing a first gate region having a first shape that surrounds the first drain region; providing a second drain region having the symmetric shape; providing a second gate region having the first shape that surrounds the second drain region; connecting a connecting gate region to the first and second gate regions; arranging a first source region adjacent to and on one side of the first gate region, the second gate region and the connecting gate region; and arranging a second source region adjacent to and on one side of side of the first gate region, the second gate region and the connecting gate region.

In other features, the symmetric shape tapers as a distance from a center of the symmetric shape increases. In other features, the method includes arranging first and second substrate contacts in the first and second source regions. The integrated circuit includes laterally-diffused MOSFET transistors.

In other features, the symmetric shape is a circular shape. The symmetric shape is an elliptical shape. The symmetric shape is a polygonal shape. The symmetric shape is a hexagonal shape.

An integrated circuit comprises first and second drain regions having a generally rectangular shape. First, second and third source regions that have a generally rectangular shape, wherein the first source region is arranged between first sides of the first and second drain regions and the second and third source regions are arranged adjacent to second sides of the first and second drain regions. A fourth source region is arranged adjacent to third sides of the first and second drain regions. A fifth source region is arranged adjacent to fourth sides of the first and second drain regions. A gate region is arranged between the first, second, third, fourth and fifth source regions and the first and second drain regions. First and second drain contacts are arranged in the first and second drain regions.

A method for providing an integrated circuit comprises providing first and second drain regions having a generally rectangular shape; arranging a first source region between first sides of the first and second drain regions; arranging second and third source regions adjacent to second sides of the first and second drain regions; arranging a fourth source region adjacent to third sides of the first and second drain regions; arranging a fifth source region adjacent to fourth sides of the first and second drain regions; arranging a gate region between the first, second, third, fourth and fifth source regions and the first and second drain region; and arranging first and second drain contacts in the first and second drain regions.

In other features of the integrated circuit and method, the first, second and third source regions have a length that is substantially equal to a length of the first drain region and wherein the fourth and fifth source regions have a length that is greater than or equal to a length of the first and second drain regions. The first, second and third source regions have a width that is less than a width of the first drain region. The width of the first, second and third source regions is approximately one-half the width of the first drain region. The fourth and fifth source regions are driven from sides thereof. The first and second drain contacts have a size that is greater than a minimum drain contact size. The drain contacts have one of a regular shape and an irregular shape. The drain contacts are one of square, rectangular, and cross-shaped. The first, second and third source regions include source contacts. The first and second drain regions and the firs, second and third source regions are arranged in a first row and further comprising N additional rows, wherein drain regions of at least one of the N additional rows share one of the fourth and fifth source regions.

An integrated circuit comprises first and second drain regions having a generally rectangular shape. First, second and third source regions that have a generally rectangular shape, wherein the first source region is arranged between first sides of the first and second drain regions and the second and third source regions are arranged adjacent to second sides of the first and second drain regions. A fourth source region is arranged adjacent to third sides of the first and second drain regions. A fifth source region is arranged adjacent to fourth sides of the first and second drain regions. A gate region is arranged between the first, second, third, fourth and fifth source regions and the first and second drain regions. First and second drain contacts are arranged in the first and second drain regions.

A method for providing an integrated circuit comprises providing first and second drain regions having a generally rectangular shape; arranging a first source region between first sides of the first and second drain regions; arranging second and third source regions adjacent to second sides of the first and second drain regions; arranging a fourth source region adjacent to third sides of the first and second drain regions; arranging a fifth source region adjacent to fourth sides of the first and second drain regions; arranging a gate region between the first, second, third, fourth and fifth source regions and the first and second drain region; and arranging first and second drain contacts in the first and second drain regions.

In other features of the integrated circuit and method, the first, second and third source regions have a length that is substantially equal to a length of the first drain region and wherein the fourth and fifth source regions have a length that is greater than or equal to a length of the first and second drain regions. The first, second and third source regions have a width that is less than a width of the first drain region. The width of the first, second and third source regions is approximately one-half the width of the first drain region. The fourth and fifth source regions are driven from sides thereof. The first and second drain contacts have a size that is greater than a minimum drain contact size. The drain contacts have one of a regular shape and an irregular shape. The drain contacts are one of square, rectangular, and cross-shaped. The first, second and third source regions include source contacts. The first and second drain regions and the firs, second and third source regions are arranged in a first row and further comprising N additional rows, wherein drain regions of at least one of the N additional rows share one of the fourth and fifth source regions.

Further regions of applicability of the present invention will become apparent from the detailed description provided hereinafter. It should be understood that the detailed description and specific examples, while indicating the preferred embodiment of the invention, are intended for purposes of illustration only and are not intended to limit the scope of the invention.

### BRIEF DESCRIPTION OF THE DRAWINGS

The present invention will become more fully understood from the detailed description and the accompanying drawings, wherein:

FIG. 1 is an electrical symbol for a transistor with a drain, source, gate and body according to the prior art;

FIG. 2 is an electrical symbol for a transistor with a drain, source, gate and body, which is connected to the source according to the prior art;

FIG. 3 is an exemplary layout of the transistor of FIG. 2 according to the prior art;

FIG. 4 is an exemplary layout of multiple transistors that are arranged in a row according to the prior art;

FIG. 5A is a first exemplary layout of transistors including a body that is arranged in the source;

FIG. 5B is a second exemplary layout of transistors including a body having edges that align with the gates in plan view;

FIG. 6 is a second exemplary layout of transistors including a body that is arranged in the source;

FIG. 7 is a third exemplary layout of transistors including a body that is arranged in the source;

FIG. 8 is a fourth exemplary layout of transistors including a body that is arranged in the source;

FIG. 9 is a fifth exemplary layout of transistors including a body that is arranged in the source;

FIG. 10 is a cross-sectional view of a PMOS transistor according to the prior art;

FIG. 11 is a plan view of a sixth exemplary layout including well substrate contacts;

FIG. 12A is a plan view of a seventh exemplary layout for reducing R_{DSon};

FIG. 12B is a plan view of the seventh exemplary layout of FIG. 12A;

FIG. 12C is a plan view of an eighth exemplary layout for reducing R_{DSon};

FIG. 12D is a plan view of a ninth exemplary layout for reducing R_{DSon} that is similar to FIG. 12C;

FIG. 12E is a plan view of a tenth exemplary layout for reducing R_{DSon} that is similar to FIG. 12C;

FiGs. 12F-12I illustrate other exemplary drain contacts;

FIG. 13 is a plan view of a eleventh exemplary layout for reducing R_{DSon}; and;

FIG. 14 is a plan view of a twelfth exemplary layout for reducing R_{DSon};

FIG. 15 is a plan view of a thirteenth exemplary layout for reducing R_{DSon}.

### DETAILED DESCRIPTION OF THE PREFERRED EMBODIMENTS

The following description of the preferred embodiment(s) is merely exemplary in nature and is in no way intended to limit the invention, its application, or uses. For purposes of clarity, the same reference numbers will be used in the drawings to identify the same elements. Additional transistors can be arranged on one or more sides of the illustrated transistors that are shown in the FiGs. as indicated by "..." in the FIGs.

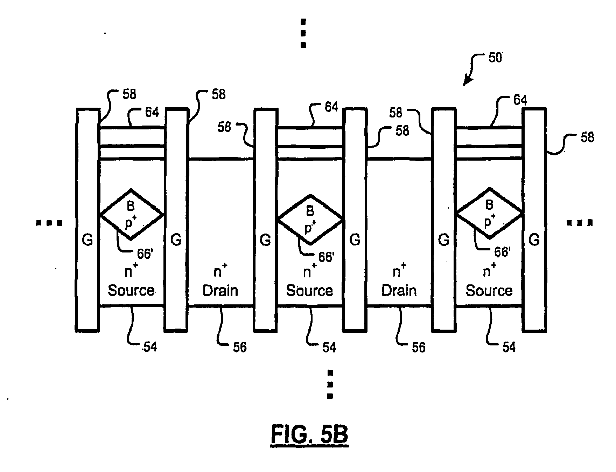

Referring now to FiGs. 5A and 5B, a transistor 50 according to the present invention is shown to include one or more sources 54 and one or more drains 56. The sources 54 and the drains 56 include n⁺ regions. While an NMOS transistor is shown, skilled artisans will appreciate that the present invention also applies to other types of transistors such as PMOS transistors. Gates 58 are located between adjacent pairs of sources 54 and drains 56. In one implementation, the gates 58 that are located on opposite sides of the sources 54 are connected together as shown at 64. In other configurations, however, the gates 58 need not be connected together.

A body 66 including a p⁺ region is arranged inside of and is surrounded by the source 54. The body 66 preferably has a shape that tapers as a distance between a midportion of the body 66 and adjacent gates decreases. The body 66 may touch or not touch the gates 58 in the plan views of FIGs. 5A and 5B. In other words, one or both edges of the body 66 may be spaced from the gates 58 in plan view (as shown in FIG. 5A) and/or substantially aligns with the gates in plan view (as shown in FIG. 5B). By utilizing some of the area of the source 54 for the body 66, the overall size of the transistor 50 is reduced as compared to conventional transistors. In the exemplary implementation that is shown in FIG. 5, the body 66 has a diamond shape.

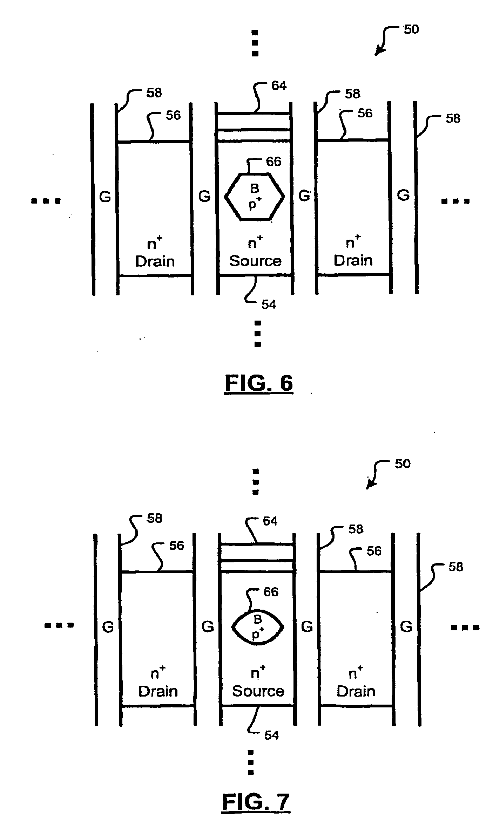

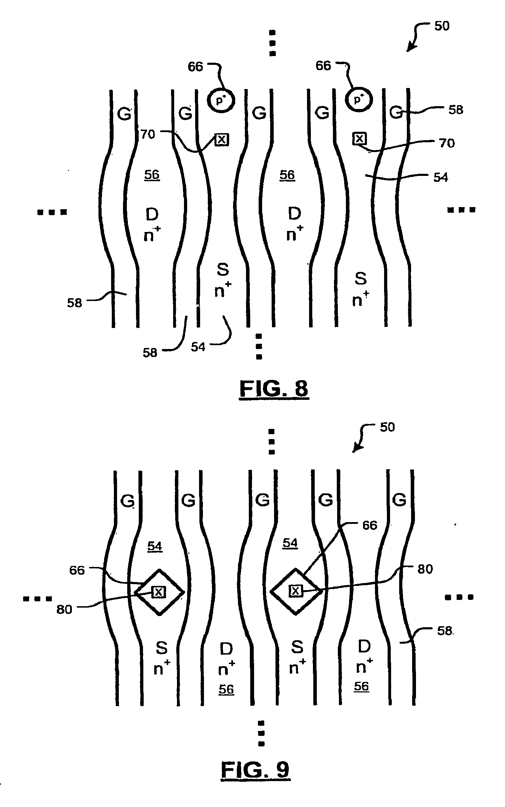

Referring now to FIGs. 6 and 7, other exemplary shapes for the body 66 are shown. In FIG. 6, the body 66 has a hexagon shape. In FIG. 7, the body is generally football shaped. Skilled artisans will appreciate that there are a wide variety of other suitable shapes. For example, a circular body is shown in FIG. 8, which is described. Other suitable shapes include an ellipse, an octagon, etc.

Referring now to FiGs. 8 and 9, the gates 58 can be arranged such that they are closer together when there are no contact taps and further apart when there are contact taps. In FIG. 8, a source contact tap 70, which is not located in the body 66, is located in a region where the adjacent gates 58 are located farther apart. In FIG. 9, a body contact tap 80, which is located in the body 66, is located in the source 54 where the adjacent gates 58 are located farther apart.

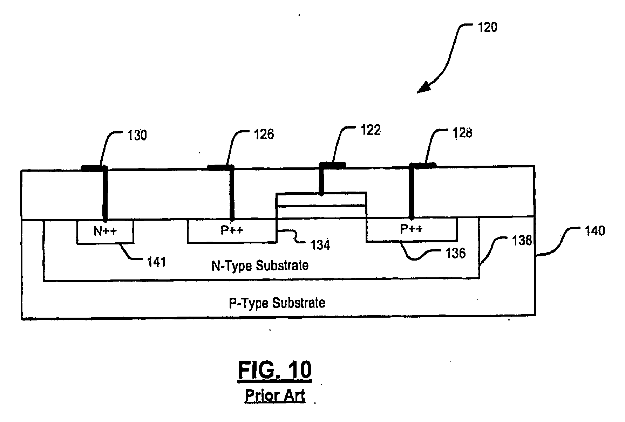

Referring now to FIG. 10, a PMOS transistor 120 is shown. The transistor 120 includes a gate contact 122, a source contact 126, a drain contact 128 and a negative (N)-well contact 130. The source contact 126 provides a connection to a P++ region 134 formed an N-type substrate layer 138. The N-type layer 138, in turn, is formed in a P-type substrate 140. The P++ region 134 forms the source. The drain contact 128 provides an electrical connection to a P++ region 136 formed in the N-type layer 138. The P++ region 136 forms the drain. The N-well contact 130 provides a connection to an N++ region 141 or N-well.

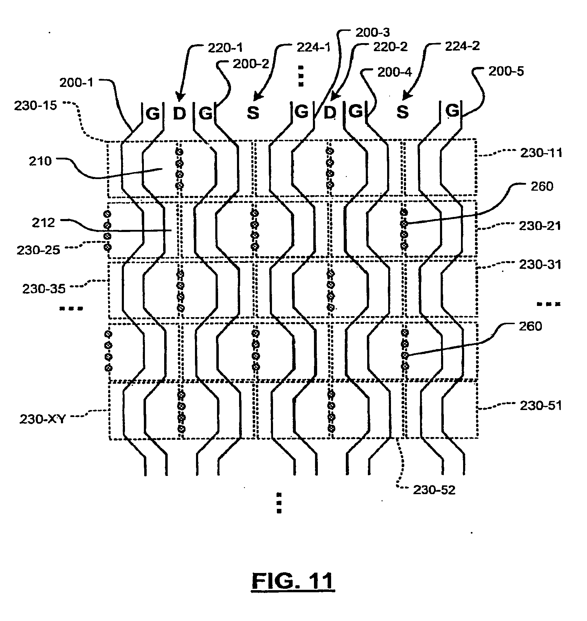

Referring now to FIG. 11, a plan view of a sixth exemplary layout is shown. For some transistor designs such as PMOS and/or NMOS transistors, electrostatic discharge (ESD) is less important than other design criteria. Therefore, N-well contact areas can be minimized. For PMOS transistors, the N-well contact area may be approximately 2.5 to 3 times the area in NMOS transistors. The source-drain resistance may be less important. Therefore, the layout in FIG. 11 minimizes the N-well contact areas and the source-drain area. Skilled artisans will appreciate that while the foregoing description relates to PMOS transistors, similar principles apply to NMOS transistors.

In a layout shown in FIG. 11, gate regions 200-1, 200-2, ..., and 200-G (collectively gate regions or gates 200) are defined between source regions 224-1, 224-2, ..., and 224-S (collectively source regions 224) and drain regions 220-1, 220-2, ..., and 220-D (collectively drain regions 220). Adjacent gates 200-1 and 200-2 define regions 210 having a wider width than adjacent regions 212 having narrower widths. Drain regions 220 and source regions 224 are alternately defined between the adjacent gates 200.

Groups of transistors 230-11, 230-12, ..., and 230-XY (collectively groups of transistors 230) are arranged adjacent to each other. Adjacent groups of transistors 230 share R N-well contacts 260, where R is an integer greater than one. The R N-well contacts 260 can be located between the adjacent groups of transistors 230 in regions 210 where the gates 200 are spaced further apart.

The source-drain area is minimized by this layout. For example, each group may include 4-6 transistors. The R N-well contacts 260 are provided for adjacent groups in both vertical and horizontal directions. Therefore, abutting edges of the adjacent groups without the R N-well contacts 260 can be located in regions 212 where the gates are spaced closer together. In other words, the gates 200 can be arranged closer together to minimize areas of the regions 212 without the R N-well contacts 260.

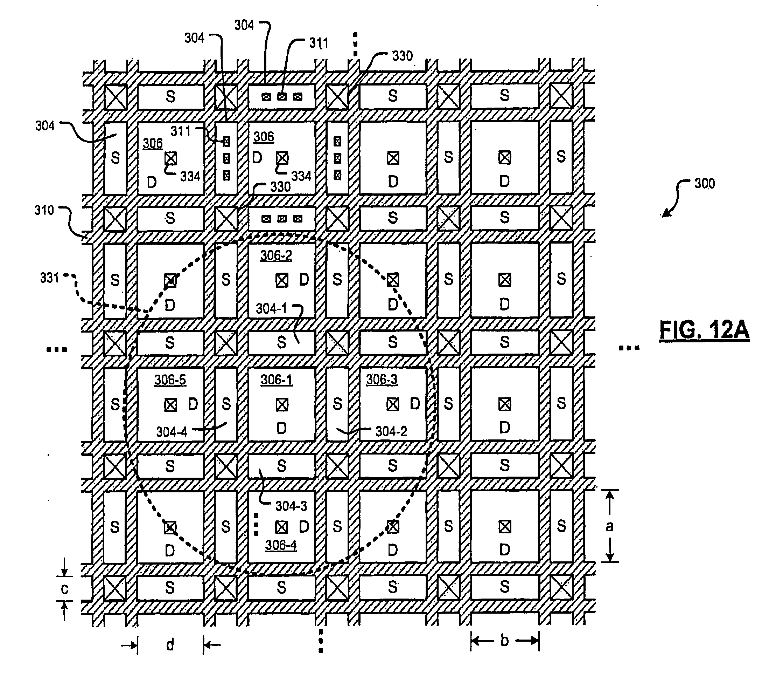

Referring now to FIG. 12A, an exemplary high-density layout for laterally diffused MOSFET (LDMOS) transistors 300 is shown. The layout tends to reduce turn-on drain-source resistance R_{DSon}. The transistors 300 include source (S) regions 304, drain (D) regions 306 and gates 310. Some, none or all of the source regions 304 may include one or more source contacts 311. For illustration purposes, not all of the source regions 304 are shown with source contacts 311.

The gates 310 define a checkerboard pattern. Source regions 304 are arranged along sides of the drain regions 306. More particularly, the drain regions 306 may have a generally rectangular shape. The source regions 304 may be arranged along each side of the generally rectangular drain regions 306. Substrate contacts 330 may be provided adjacent to corners of the drain regions 306 at intersections between adjacent source regions 304. Drain contacts 334 may also be provided at a central location within the drain regions 306.

Each drain region 306 may be arranged adjacent to source regions 304 that are common with other adjacent drain regions 306. For example in dotted area 331 in FIG. 12A, drain region 306-1 shares the source region 304-1 with the drain region 306-2. Drain region 306-1 shares the source region 304-2 with the drain region 306-3. Drain region 306-1 shares the source region 304-3 with the drain region 306-4. Drain region 306-1 shares the source region 304-4 with the drain region 306-5. This pattern may be repeated for adjacent drain regions 306.

Each of the drain regions 306 may have an area that is greater than or equal to two times the area of each of the source regions 304. In FIG. 12A, the drain regions 306 have a width "b" and a height "a". The source regions 304 have a width (or height) "d" and a height (or width) "c". The drain regions 306 may have substantially the same length as the source regions 304. The drain regions 306 may have greater than or equal to two times the width of the source regions 304.

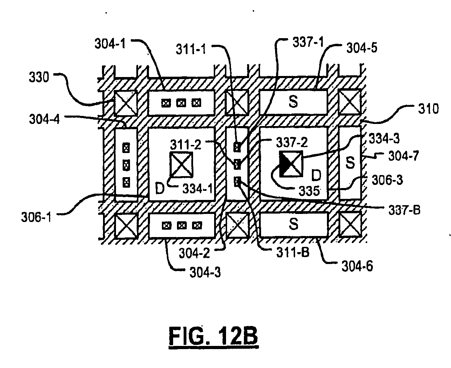

Referring now to FIG. 12B, a more detailed view of part of the layout of FIG. 12A is shown. Drain contacts 334-1 and 334-3 may be associated with drain regions 306-1 and 306-3, respectively. Substrate contacts 330 are located adjacent to corners of the drain regions 306-1. Source contacts 311-1, 311-2, ... and 311-B may be arranged in source regions 304-2 and 304-4, where B is an integer. Drain contacts 334-1 and 334-3 may be arranged in each of the drain regions 306-1 and 306-3, respectively. Drain contact 334-1 may define an area that is greater than the area of the source contact 311-1 in the source region 304-2.

Substantially all of the current flowing between the drain region 306-3 and the source contacts 311-1, 311-2, ... and 311-B of the adjacent source region 304-2 flows between a facing portion 335 of the drain contact 334-3 and facing halves 337-1, 337-2, ... and 337-S of source contacts 311-1, 311-2, ... and 311-B in the source region 304-2. Current flows in a similar manner between other facing portions of the drain contact 334-3 and source contacts (not shown) in other adjacent source regions 304-5, 304-6 and 304-7.

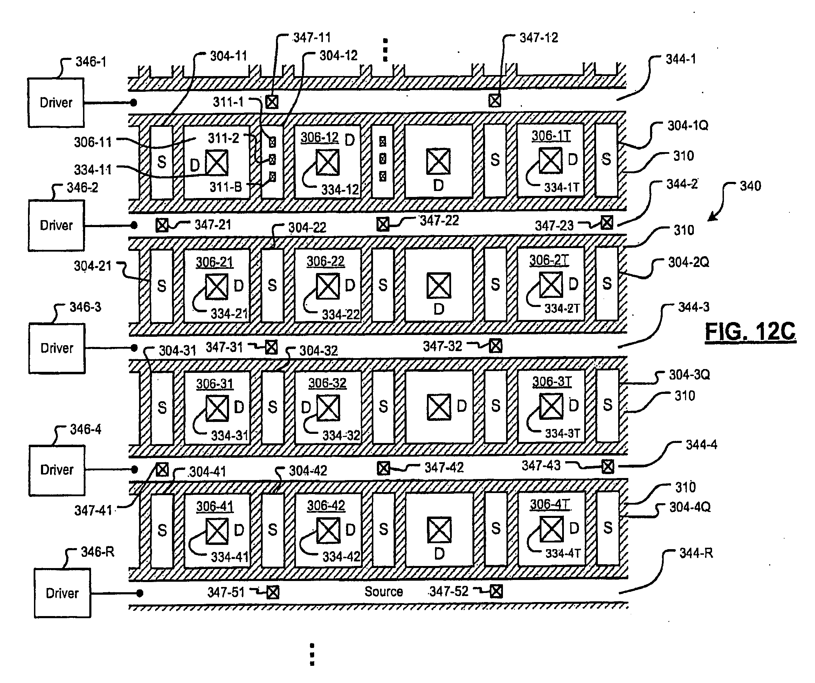

Referring now to FIG. 12C, another exemplary high-density layout for laterally diffused MOSFET (LDMOS) transistors 340 is shown. The layout tends to provide low turn-on drain-source resistance R_{DSon}. The transistors 340 include source regions 304-11, 304-12, ... 304-4Q, drain regions 306-11, 306-12, ... 306-4T and gates 310, where Q and T are integers. While four rows are shown in FIG. 12B, additional and/or fewer rows and/or columns may be employed. Some, none or all of the source regions 304 may include source contacts 311. For illustration purposes, not all of the source regions 304 are shown with source contacts. For example, source region 304-12 includes source contacts 311-1, 311-2, ... and 311-B, where B is an integer.

Other elongated source regions 344-1, 344-2, 344-3, ... and 344-R are arranged between rows (or columns) of drain regions 306 and may be driven by drivers 346-1, 346-2, ..., and 346-R arranged on one or both sides (or tops) of the layout in FIG. 12B. The elongated source regions 344-1, 344-2, 344-3, ... and 344-R may extend adjacent to sides of at least two drain regions 306 such as at least drain regions 306-11 and 306-12.

Each of the drain regions 306 (such as drain region 306-11) may have an area that is greater than or equal to two times the area of each of the source regions 304 (such as source region 304-12). The drain regions 306 (such as drain region 306-11) may have substantially the same length as the source regions 304 (such as source region 304-12). The drain regions 306 (such as drain region 306-11) may have greater than or equal to two times the width of the source regions 304 (such as source region 304-12).

Substrate contacts 347-11, 347-12, 347-21, 347-22, 347-23, ... 347-51, 347-52 (collectively substrate contacts 347) may be arranged in some, none or all of the elongated source regions 344. The placement and number of substrate contracts 347 may be uniform or varied for each of the elongated source regions 344. For example only, the substrate contacts 347 shown in FIG. 12C may be offset from the substrate contacts 347 in adjacent elongated source regions 344. Each of the elongated source regions 344 may include the same number or a different number of substrate contacts 347 than adjacent elongated source regions 344. The substrate contacts 347 may be aligned or offset as shown. Some elongated source regions 344 may include no substrate contacts 347. Still other variations are contemplated.

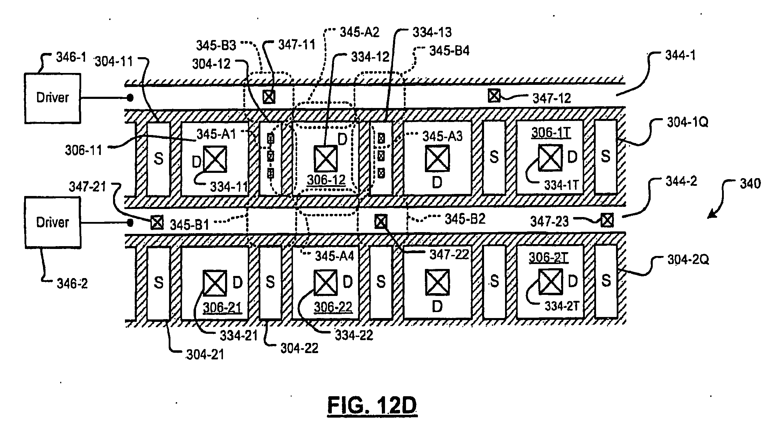

Referring now to FIG. 12D, first areas 345-A1, 345-A2, 345-A3 and 345-A4 may provide useful transistor areas. For example, first areas 345-A1, 345-A2, 345-A3 and 345-A4 may be located between drain region 306-12 and source regions 304-12, 344-1, 304-13, and 344-2, respectively. Second areas 345-B1, 345-B2, 345-B3 and 345-B4 may provide less useful transistor areas. For example, second areas 345-B1, 345-B2, 345-B3 and 345-B4 may be located between source regions 304-12, 344-1, 304-13, and 344-2.

In some implementations, the substrate contacts 347-11, 347-12, 347-21, 347-22, 347-23, ... may be arranged in some, none or all of the second areas 345-B1, 345-B2, 345-B3 and 345-B4 of the source regions 344-1, 344-2, ... and 344-R, for example as shown in FIG. 12D. The substrate contacts 347-11, 347-12, 347-21, 347-22, 347-23, ... are shown arranged in the elongated substrate regions 344-1 and 344-2 and tend to lower R_{DS_ON}. The substrate contacts 347-11, 347-12, 347-21, 347-22, 347-23, ... may have a height that is less than or equal to a width "c" of the source regions 304 (as shown in FIG. 12A) and a width that is less than or equal to a width "d" of the source regions 304 (as shown in FIG. 12A).

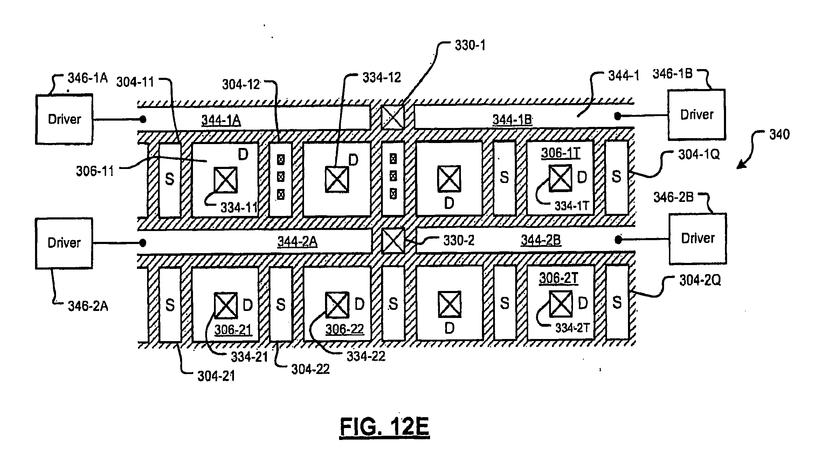

Referring now to FIG. 12E, substrate contacts 330-1 and 330-2 are provided between pairs of elongated source regions 344-1 A and 344-1 B and 344-2A and 344-2B, respectively. The elongated source regions 344-1A and 344-2A are driven from one side by drivers 346-1 A and 346-2A. The elongated source regions 344-1 B and 344-2B are driven from another side by drivers 346-1B and 346-2B.

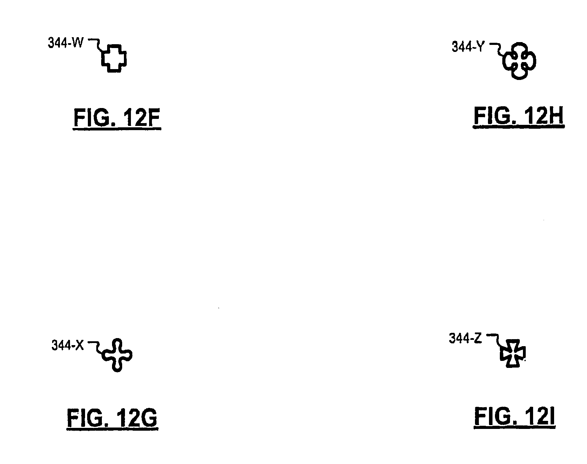

Drain contacts 334 in FiGs. 12A-12E may have a minimum size or a size that is greater than the minimum size. Drain contacts 334 may have a simple or regular shape and/or an irregular or complex shape. For example, the drain contacts 334 may have a square or rectangular shape (as shown at 344 in FIG. 12A), a cross shape (as shown at 344-W in FIG. 12F), clover-leaf shapes (as shown at 334-X and 334-Y in FIGS. 12G and 12H, respectively), a modified cross-shaped region (as shown at 334-Z in FIG. 12I) and/or other suitable shapes such as but not limited to diamond, circular, symmetric, non-symmetric, etc.. The substrate contacts 347 may similarly have a simple or regular shape and/or an irregular or complex shape similar to the drain contacts 334.

In some implementations, the number of source contacts B in a given source region may be an integer that is greater than one and less than six. In some implementations, B may be equal to 3 or 4. The area of the drain contact 334-3 may be greater than or equal to 2*B* (the area one of source contacts 311-1, 311-2, ... or 311-B). For example, when B is equal to 3, the drain contact region 334-3 may have an area that is approximately greater than or equal to 6 times an area of one source contact 311-1, 311-2, ... or 311-B. When B is equal to 4, the drain contact region 334-3 may an area that is approximately greater than or equal to 8 times an area of one source contact 311-1, 311-2, ... or 311-B.

As the size of the drain contacts 334 increases relative to the corresponding drain region 306, over-etching may occur. In other words, the etching process may adversely impact adjacent regions and/or underlying layers. To alleviate the problems of over-etching, the complex shapes in FiGs. 12F-12I and/or other complex shapes can be employed for the drain contacts 334. Alternately, the drain contacts 334 can employ deep implant ions in and/or below the drain contacts 334.

As an alternative to placing the substrate contact 330 in the elongated source regions 344, a relief area may be provided in one or both sides of the source region 344 in areas 345-B1, 345-B2, 345-B3 and 345-B. A substrate contact region 330 can be positioned in the relief area. The shape of the elongate source region 344 can be adjusted on an opposite side of the relief area to offset the effect of the relief area and to prevent reduction in current density in areas of the elongate source region 344 near the relief areas.

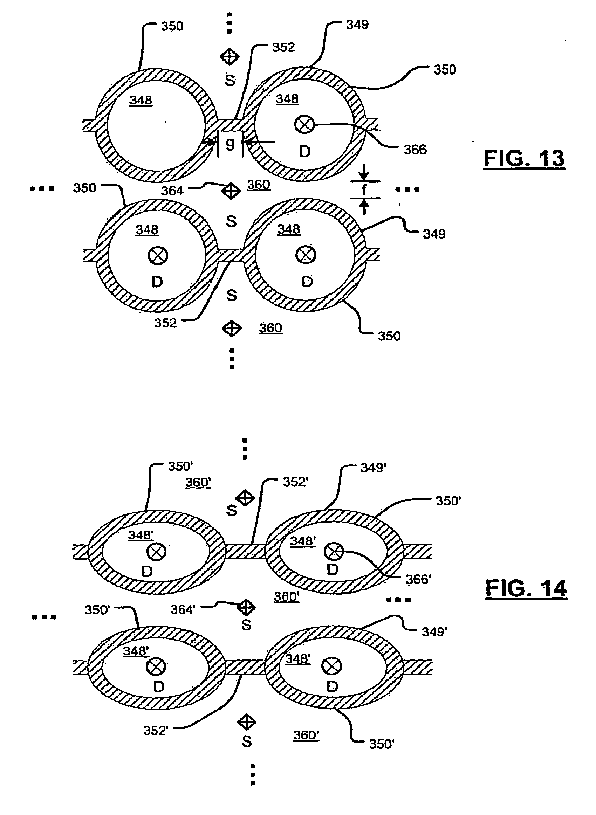

Referring now to FIGs. 13-15, drain, source and gate regions can also have other shapes that can be used to minimize R_{DSON}. For example, drain regions 348 can have a circular shape as shown in FIG. 13, an elliptical shape as shown in FIG. 14 and/or other suitable shapes. Gate regions 349 include circular-shaped gate regions 350 that are connected by linear gate connecting regions 352. Similar elements are identified in FIG. 14 using a prime symbol ("'"). The drain regions 348 are located in the circular-shaped gate regions 350. Source regions 360 are located in between the gate regions 349 in areas other than the inside of the circular shaped gate regions 350. Substrate contacts 364 are located in the source regions 360. The drain regions 348 may also include a contact region 366. The linear gate regions 352 may have a vertical spacing "g" that is minimized to increase density. Likewise, lateral spacing identified at "f" between adjacent circular-shaped gate regions 350 may be minimized to increase density.

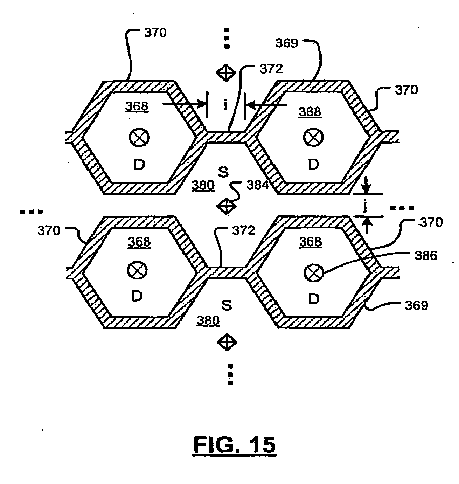

Drain areas 368 can also have polygon shapes. For example, the drain areas can have a hexagon shape as shown in FIG. 15, although other polygon shapes can be used. Gate regions 369 include hexagon-shaped gate regions 370 that are connected by linear gate connecting regions 372. The drain regions 368 are located in the hexagon-shaped gate regions 370. Source regions 380 are located in between the gate regions 369 in areas other than the inside of the hexagon-shaped gate regions 370. Substrate contacts 384 are located in the source regions 380. The drain regions may also include a contact region 386. The linear gate connecting regions 372 preferably have a vertical spacing "j" that is minimized to increase density. Likewise lateral spacing identified at "i" between adjacent hexagon-shaped gate regions 370 is minimized to increase density.

As can be appreciated, the shapes for the drain and gate areas in FIGs. 13-15 can be any shape that is symmetric about at least one of the horizontal and vertical centerlines of the drain areas. The transistors in FIGs. 13-15 may be LDMOS transistors. The shape of the drain regions may include any symmetric shape. The shape may taper as a distance from a center point of the drain area increases and/or as a center point of the drain area increases in a direction towards one or more other transistors.

Various exemplary implementations incorporating the teachings of the present disclosure are discussed.

The teachings of the disclosure can be implemented in transistors of a hard disk drive (HDD). The HDD includes a hard disk assembly (HDA) and a HDD PCB. The HDA may include a magnetic medium, such as one or more platters that store data, and a read/write device. The read/write device may be arranged on an actuator arm and may read and write data on the magnetic medium. Additionally, the HDA includes a spindle motor that rotates the magnetic medium and a voice-coil motor (VCM) that actuates the actuator arm. A preamplifier device amplifies signals generated by the read/write device during read operations and provides signals to the read/write device during write operations.

The HDD PCB includes a read/write channel module (hereinafter, "read channel"), a hard disk controller (HDC) module, a buffer, nonvolatile memory, a processor, and a spindle/VCM driver module. The read channel processes data received from and transmitted to the preamplifier device. The HDC module controls components of the HDA and communicates with an external device (not shown) via an I/O interface. The external device may include a computer, a multimedia device, a mobile computing device, etc. The I/O interface may include wireline and/or wireless communication links.

The HDC module may receive data from the HDA, the read channel, the buffer, nonvolatile memory, the processor, the spindle/VCM driver module, and/or the I/O interface. The processor may process the data, including encoding, decoding, filtering, and/or formatting. The processed data may be output to the HDA, the read channel, the buffer, nonvolatile memory, the processor, the spindle/VCM driver module, and/or the I/O interface.

The HDC module may use the buffer and/or nonvolatile memory to store data related to the control and operation of the HDD. The buffer may include DRAM, SDRAM, etc. The nonvolatile memory may include flash memory (including NAND and NOR flash memory), phase change memory, magnetic RAM, or multi-state memory, in which each memory cell has more than two states. The spindle/VCM driver module controls the spindle motor and the VCM. The HDD PCB includes a power supply that provides power to the components of the HDD.

The teachings of the disclosure can further implemented in transistors of a DVD drive or of a CD drive. The DVD drive includes a DVD PCB and a DVD assembly (DVDA). The DVD PCB includes a DVD control module, a buffer, nonvolatile memory, a processor 424, a spindle/FM (feed motor) driver module, an analog front-end module, a write strategy module, and a DSP module.

The DVD control module controls components of the DVDA and communicates with an external device (not shown) via an I/O interface. The external device may include a computer, a multimedia device, a mobile computing device, etc. The I/O interface may include wireline and/or wireless communication links.

The DVD control module may receive data from the buffer, nonvolatile memory, the processor, the spindle/FM driver module, the analog front-end module, the write strategy module, the DSP module, and/or the I/O interface. The processor may process the data, including encoding, decoding, filtering, and/or formatting. The DSP module performs signal processing, such as video and/or audio coding/decoding. The processed data may be output to the buffer, nonvolatile memory, the processor, the spindle/FM driver module, the analog front-end module, the write strategy module, the DSP module, and/or the I/O interface.

The DVD control module may use the buffer and/or nonvolatile memory to store data related to the control and operation of the DVD drive. The buffer may include DRAM, SDRAM, etc. The nonvolatile memory may include flash memory (including NAND and NOR flash memory), phase change memory, magnetic RAM, or multi-state memory, in which each memory cell has more than two states. The DVD PCB includes a power supply that provides power to the components of the DVD drive.

The DVDA may include a preamplifier device, a laser driver, and an optical device, which may be an optical read/write (ORW) device or an optical read-only (OR) device. A spindle motor rotates an optical storage medium, and a feed motor actuates the optical device relative to the optical storage medium.

When reading data from the optical storage medium, the laser driver provides a read power to the optical device. The optical device detects data from the optical storage medium, and transmits the data to the preamplifier device. The analog front-end module receives data from the preamplifier device and performs such functions as filtering and A/D conversion. To write to the optical storage medium, the write strategy module transmits power level and timing information to the laser driver. The laser driver controls the optical device to write data to the optical storage medium.

The teachings of the disclosure can further be implemented in a transistors of a high definition television (HDTV). The HDTV includes a HDTV control module, a display, a power supply, memory, a storage device, a WLAN interface and associated antenna 444, and an external interfaces.

The HDTV can receive input signals from the WLAN interface and/or the external interface, which sends and receives information via cable, broadband Internet, and/or satellite. The HDTV control module may process the input signals, including encoding, decoding, filtering, and/or formatting, and generate output signals. The output signals may be communicated to one or more of the display, memory, the storage device, the W LAN interface, and the external interface.

Memory may include random access memory (RAM) and/or nonvolatile memory such as flash memory, phase change memory, or multi-state memory, in which each memory cell has more than two states. The storage device may include an optical storage drive, such as a DVD drive, and/or a hard disk drive (HDD). The HDTV control module communicates externally via the WLAN interface and/or the external interface. The power supply provides power to the components of the HDTV.

The teachings of the disclosure may be implemented in a transistors of a vehicle. The vehicle may include a vehicle control system, a power supply, memory, a storage device, and a WLAN interface and associated antenna. The vehicle control system may be a powertrain control system, a body control system, an entertainment control system, an anti-lock braking system (ABS), a navigation system, a telematics system, a lane departure system, an adaptive cruise control system, etc.

The vehicle control system may communicate with one or more sensors and generate one or more output signals. The sensors may include temperature sensors, acceleration sensors, pressure sensors, rotational sensors, airflow sensors, etc. The output signals may control engine operating parameters, transmission operating parameters, suspension parameters, etc.

The power supply provides power to the components of the vehicle. The vehicle control system 447 may store data in Memory and/or the storage device. Memory may include random access memory (RAM) and/or nonvolatile memory such as flash memory, phase change memory, or multi-state memory, in which each memory cell has more than two states. The storage device may include an optical storage drive, such as a DVD drive, and/or a hard disk drive (HDD). The vehicle control system may communicate externally using the WLAN interface.

The teachings of the disclosure can further be implemented in a transistors of a cellular phone. The cellular phone includes a phone control module, a power supply, memory, a storage device, and a cellular network interface. The cellular phone may include a WLAN interface and associated antenna, a microphone, an audio output such as a speaker and/or output jack, a display, and a user input device such as a keypad and/or pointing device.

The phone control module may receive input signals from the cellular network interface, the WLAN interface, the microphone, and/or the user input device. The phone control module may process signals, including encoding, decoding, filtering, and/or formatting, and generate output signals. The output signals may be communicated to one or more of memory, the storage device, the cellular network interface, the WLAN interface, and the audio.

Memory may include random access memory (RAM) and/or nonvolatile memory such as flash memory, phase change memory, or multi-state memory, in which each memory cell has more than two states. The storage device may include an optical storage drive, such as a DVD drive, and/or a hard disk drive (HDD). The power supply 462 provides power to the components of the cellular phone.

The teachings of the disclosure can further be implemented in a transistors of a set top box. The set top box includes a set top control module, a display, a power supply, memory, a storage device, and a WLAN interface and associated antenna.

The set top control module may receive input signals from the WLAN interface and an external interface, which can send and receive information via cable, broadband Internet, and/or satellite. The set top control module may process signals, including encoding, decoding, filtering, and/or formatting, and generate output signals. The output signals may include audio and/or video signals in standard and/or high definition formats. The output signals may be communicated to the WLAN interface and/or to the display. The display may include a television, a projector, and/or a monitor.

The power supply provides power to the components of the set top box. Memory may include random access memory (RAM) and/or nonvolatile memory such as flash memory, phase change memory, or multi-state memory, in which each memory cell has more than two states. The storage device may include an optical storage drive, such as a DVD drive, and/or a hard disk drive (HDD).

The teachings of the disclosure can further be implemented in a transistors of a media player. The media player may include a media player control module, a power supply, memory, a storage device, a WLAN interface and associated antenna, and an external interface.

The media player control module may receive input signals from the WLAN interface and/or the external interface. The external interface may include USB, infrared, and/or Ethernet. The input signals may include compressed audio and/or video, and may be compliant with the MP3 format. Additionally, the media player control module may receive input from a user input such as a keypad, touchpad, or individual buttons. The media player control module may process input signals, including encoding, decoding, filtering, and/or formatting, and generate output signals.

The media player control module may output audio signals to an audio output and video signals to a display. The audio output may include a speaker and/or an output jack. The display may present a graphical user interface, which may include menus, icons, etc. The power supply provides power to the components of the media player. Memory may include random access memory (RAM) and/or nonvolatile memory such as flash memory, phase change memory, or multi-state memory, in which each memory cell has more than two states. The storage device may include an optical storage drive, such as a DVD drive, and/or a hard disk drive (HDD).

### List of Embodiments:

1. An integrated circuit comprising:
   a first source;
   a first drain;
   a second source;
   a first gate arranged between said first source and said first drain; and
   a second gate arranged between said first drain and said second source,
   wherein said first and second gates define alternating first and second regions in said drain, wherein said first and second gates are arranged farther apart in said first regions than in said second regions.
2. The integrated circuit of embodiment 1 further comprising a well substrate contact arranged in said first regions.
3. The integrated circuit of embodiment 1 further comprising R well substrate contacts arranged in said first regions, where R is an integer greater than one.
4. The integrated circuit of embodiment 3 wherein R is an integer that is greater than three and less than seven.
5. The integrated circuit of embodiment 1 wherein said integrated circuit includes a plurality of transistors.
6. The integrated circuit of embodiment 5 wherein said transistors include PMOS transistors.
7. The integrated circuit of embodiment 3 wherein said R well substrate contacts are associated with respective ones of R transistors.
8. The integrated circuit of embodiment 1 further comprising:
   a second drain;
   a third gate arranged between said second source and said second drain,
   wherein said second and third gates define alternating third and fourth regions, said second and third gates are arranged farther apart in said third regions than in said fourth regions.
9. The integrated circuit of embodiment 8 wherein said first regions are arranged adjacent to said fourth regions and said second regions are arranged adjacent to said third regions.
10. The integrated circuit of embodiment 9 wherein said first and third regions include R well substrate contacts.
11. A method for providing an integrated circuit comprising:
   providing a first source;
   providing a first drain;
   providing a second source;
   locating a first gate between said first source and said first drain;
   locating a second gate between said first drain and said second source;
   defining alternating first and second regions in said drain using said first and second gates; and
   arranging said first and second gates farther apart in said first regions than in said second regions.
12. The method of embodiment 11 further comprising locating a well substrate contact in said first regions.
13. The method of embodiment 11 further comprising locating R well substrate contacts in said first regions, where R is an integer greater than one.
14. The method of embodiment 13 wherein R is an integer that is greater than three and less than seven.
15. The method of embodiment 11 wherein said integrated circuit includes a plurality of transistors.
16. The method of embodiment 15 wherein said transistors include PMOS transistors.
17. The method of embodiment 13 further comprising associating said R well substrate contacts with respective ones of R transistors.
18. The method of embodiment 11 further comprising:
   providing a second drain;
   providing a third gate between said second source and said second drain;
   defining alternating third and fourth regions using said second and third gates; and
   arranging said second and third gates are arranged farther apart in said third regions than in said fourth regions.
19. The method of embodiment 18 further comprising arranging said first regions adjacent to said fourth regions and said second regions adjacent to said third regions.
20. The method of embodiment 19 wherein said first and third regions include R well substrate contacts, where R is an integer greater than one.
21. An integrated circuit comprising:
   a first drain region having a generally rectangular shape;
   first, second, third and fourth source regions that have a generally rectangular shape and that are arranged adjacent to sides of said first drain region;
   a gate region that is arranged between said first, second, third and fourth source regions and said first drain region; and
   first, second, third and fourth substrate contact regions that are arranged adjacent to corners of said first drain region.
22. The integrated circuit of embodiment 21 wherein said first, second, third and fourth source regions have a length that is substantially equal to a length of said drain region.
23. The integrated circuit of embodiment 21 wherein said first, second, third and fourth source regions have a width that is less than a width of said first drain region.
24. The integrated circuit of embodiment 23 wherein said width of said first, second, third and fourth source regions is approximately one-half the width of said first drain region.
25. The integrated circuit of embodiment 21 further comprising
   a second drain region having a generally rectangular shape and having one side that is arranged adjacent to said first source region; and
   fifth, sixth and seventh source regions that have a generally rectangular shape and that are arranged adjacent to other sides of said second drain region.
26. The integrated circuit of embodiment 25 further comprising a gate region that is arranged between said first, fifth, sixth and seventh source regions and said second drain region.
27. The integrated circuit of embodiment 26 further comprising fifth and sixth substrate contact regions that are arranged adjacent to corners of said second drain region.
28. The integrated circuit of embodiment 21 wherein said integrated circuit includes laterally-diffused MOSFET transistors.
29. The integrated circuit of embodiment 21 further comprising B source contacts in each of said first, second, third, and fourth source regions, where B is an integer greater than one and a drain contact region.
30. The integrated circuit of embodiment 29 wherein said first and second drain contacts have an area D and said B source contacts have an area A and wherein said area D is greater than or equal to 2*B*A.
31. A method for providing an integrated circuit comprising:
   providing a first drain region having a generally rectangular shape;
   arranging sides of first, second, third and fourth source regions, which have a generally rectangular shape, adjacent to sides of said first drain region;
   arranging a gate region between said first, second, third and fourth source regions and said first drain region; and
   arranging first, second, third and fourth substrate contact regions adjacent to corners of said first drain region.
32. The method of embodiment 31 wherein said first, second, third and fourth source regions have a length that is substantially equal to a length of said drain region.
33. The method of embodiment 31 wherein said first, second, third and fourth source regions have a width that is less than a width of said first drain region.
34. The method of embodiment 31 wherein said width of said first, second, third and fourth source regions is approximately one-half the width of said first drain region.
35. The method of embodiment 31 further comprising
   arranging one side of a second drain region, which has a generally rectangular shape, adjacent to said first source region; and
   arranging fifth, sixth and seventh source regions, which have a generally rectangular shape, adjacent to other sides of said second drain region.
36. The method of embodiment 35 further comprising arranging a gate region between said first, fifth, sixth and seventh source regions and said second drain region.
37. The method of embodiment 36 further comprising arranging fifth and sixth substrate contact regions adjacent to corners of said second drain region.
38. The method of embodiment 31 wherein said integrated circuit includes laterally-diffused MOSFET transistors.
39. The method of embodiment 31 further comprising arranging B source contacts in each of said first, second, third and fourth source regions, where B is an integer greater than one and a drain contact region in said drain region.
40. The method of embodiment 39 wherein said first and second drain contacts have an area D and said B source contacts have an area A and wherein said area D is greater than or equal to 2*B*A.
41. An integrated circuit comprising:
   a first drain region having a symmetric shape across at least one of horizontal and vertical centerlines;
   a first gate region having a first shape that surrounds said first drain region;
   a second drain region having said symmetric shape;
   a second gate region having said first shape that surrounds said second drain region;
   a connecting gate region connecting said first and second gate regions;
   a first source region arranged adjacent to and on one side of said first gate region, said second gate region and said connecting gate region; and
   a second source region arranged adjacent to and on one side of side of said first gate region, said second gate region and said connecting gate region.
42. The integrated circuit of embodiment 41 wherein said symmetric shape tapers as a distance from a center of said symmetric shape increases.
43. The integrated circuit of embodiment 41 further comprising first and second substrate contacts arranged in said first and second source regions.
44. The integrated circuit of embodiment 41 wherein said integrated circuit includes laterally-diffused MOSFET transistors.
45. The integrated circuit of embodiment 41 wherein said symmetric shape is a circular shape.
46. The integrated circuit of embodiment 41 wherein said symmetric shape is an elliptical shape.
47. The integrated circuit of embodiment 41 wherein said symmetric shape is a polygonal shape.
48. The integrated circuit of embodiment 41 wherein said symmetric shape is a hexagonal shape.
49. A method for providing an integrated circuit comprising:
   providing a first drain region having a symmetric shape across at least one of horizontal and vertical centerlines;
   providing a first gate region having a first shape that surrounds said first drain region;
   providing a second drain region having said symmetric shape;
   providing a second gate region having said first shape that surrounds said second drain region;
   connecting a connecting gate region to said first and second gate regions;
   arranging a first source region adjacent to and on one side of said first gate region, said second gate region and said connecting gate region; and
   arranging a second source region adjacent to and on one side of side of said first gate region, said second gate region and said connecting gate region.
50. The method of embodiment 49 wherein said symmetric shape tapers as a distance from a center of said symmetric shape increases.
51. The method of embodiment 49 further comprising arranging first and second substrate contacts in said first and second source regions.
52. The method of embodiment 49 wherein said integrated circuit includes laterally-diffused MOSFET transistors.
53. The method of embodiment 49 wherein said symmetric shape is a circular shape.
54. The method of embodiment 49 wherein said symmetric shape is an elliptical shape.
55. The method of embodiment 49 wherein said symmetric shape is a polygonal shape.
56. The method of embodiment 49 wherein said symmetric shape is a hexagonal shape.
57. An integrated circuit comprising:
   first and second drain regions having a generally rectangular shape;
   first, second and third source regions that have a generally rectangular shape, wherein said first source region is arranged between first sides of said first and second drain regions and said second and third source regions are arranged adjacent to second sides of said first and second drain regions;
   fourth and fifth source regions, wherein said fourth source region is arranged adjacent to third sides of said first and second drain regions and wherein said fifth source region is arranged adjacent to fourth sides of said first and second drain regions;
   a gate region that is arranged between said first, second, third, fourth and fifth source regions and said first and second drain regions; and
   first and second drain contacts that are arranged in said first and second drain regions.
58. The integrated circuit of embodiment 57 wherein said first, second and third source regions have a length that is substantially equal to a length of said first drain region and wherein said fourth and fifth source regions have a length that is greater than or equal to a length of said first and second drain regions.
59. The integrated circuit of embodiment 57 wherein said first, second and third source regions have a width that is less than a width of said first drain region.
60. The integrated circuit of embodiment 59 wherein said width of said first, second and third source regions is approximately one-half the width of said first drain region.
61. The integrated circuit of embodiment 57 wherein said fourth and fifth source regions are driven from sides thereof.
62. The integrated circuit of embodiment 57 wherein said first and second drain contacts have a size that is greater than a minimum drain contact size.
63. The integrated circuit of embodiment 57 wherein said drain contacts have one of a regular shape and an irregular shape.
64. The integrated circuit of embodiment 57 wherein said drain contacts are one of square, rectangular, and cross-shaped.
65. The integrated circuit of embodiment 57 wherein said first, second and third source regions include source contacts.
66. The integrated circuit of embodiment 57 wherein said first and second drain regions and said first, second and third source regions are arranged in a first row and further comprising N additional rows, wherein drain regions of at least one of said N additional rows share one of said fourth and fifth source regions.
67. The integrated circuit of embodiment 57 further comprising at least one substrate contact arranged in at least one of said fourth and fifth source regions.
68. The integrated circuit of embodiment 67 wherein said at least one of said fourth and fifth source regions includes a relief area and further comprising arranging said substrate contact region in said relief area.
69. The integrated circuit of embodiment 67 wherein said at least one substrate contact has first and second dimensions that are less than corresponding first and second dimensions of said at least one of said fourth and fifth source regions.
70. The integrated circuit of embodiment 57 further comprising B source contacts arranged in each of said first, second and third source regions, where B is an integer greater than one.
71. The integrated circuit of embodiment 70 wherein said first and second drain contacts have an area D and said B source contacts have an area A and wherein said area D is greater than or equal to 2*B*A.
72. The integrated circuit of embodiment 71 where B is equal to one of 3 or 4.
73. The integrated circuit of embodiment 57 further comprising
   a third drain region having a generally rectangular shape that is arranged adjacent to said third source region;
   a sixth source region that has a generally rectangular shape and that is arranged adjacent to said third drain region;
   seventh and eighth source regions arranged adjacent to said third drain region and said sixth source region; and
   a substrate contact arranged between said fourth and fifth source regions and said seventh and eighth source regions.
74. The integrated circuit of embodiment 73 wherein said seventh and eighth source regions are co-linear with said fourth and fifth source regions and wherein said seventh and eighth source regions are driven from one side of said integrated circuit and said fourth and fifth source regions are driven from an opposite side of said integrated circuit.
75. The integrated circuit of embodiment 68 wherein said relief area is arranged along an edge of at least one of said fourth and fifth source regions.
76. The integrated circuit of embodiment 68 wherein said relief area is arranged in a center portion of at least one of said fourth and fifth source regions.
77. The integrated circuit of embodiment 57 wherein said integrated circuit includes laterally-diffused MOSFET transistors.

## Claims

1. An integrated circuit comprising:
first (306-31) and second (306-32) drain regions having a generally rectangular shape;
first (304-32), second (304-31) and third source regions that have a generally rectangular shape, wherein said first source region is arranged between first sides of said first and second drain regions and said second and third source regions are arranged adjacent to second sides of said first and second drain regions;
fourth (344-3) and fifth (344-4) source regions, wherein said fourth source region is arranged adjacent to third sides of said first and second drain regions and wherein said fifth source region is arranged adjacent to fourth sides of said first and second drain regions;
a gate region (310) that is arranged between said first, second, third, fourth and fifth source regions and said first and second drain regions; and
first (334-31) and second (334-32) drain contacts that are arranged in said first and second drain regions;
wherein said first, second, and third source regions are surrounded by said gate region.

2. The integrated circuit of claim 1 wherein said first, second and third source regions have a length that is substantially equal to a length of said first drain region and wherein said fourth and fifth source regions have a length that is greater than or equal to a length of said first and second drain regions.

3. The integrated circuit of claim 1 wherein said first, second and third source regions have a width that is less than a width of said first drain region.

4. The integrated circuit of claim 3 wherein said width of said first, second and third source regions is approximately one-half the width of said first drain region.

5. The integrated circuit of claim 1 wherein said fourth and fifth source regions are driven from sides thereof.

6. The integrated circuit of claim 1 wherein said first and second drain contacts have a size that is greater than a minimum drain contact size.

7. The integrated circuit of claim 1 wherein said drain contacts have one of a regular shape and an irregular shape.

8. The integrated circuit of claim 1 wherein said drain contacts are one of square, rectangular, and cross-shaped.

9. The integrated circuit of claim 1 wherein said first, second and third source regions include source contacts.

10. The integrated circuit of claim 1 wherein said first and second drain regions and said first, second and third source regions are arranged in a first row and further comprising N additional rows, wherein drain regions of at least one of said N additional rows share one of said fourth and fifth source regions.

11. The integrated circuit of claim 1 further comprising at least one substrate contact arranged in at least one of said fourth and fifth source regions.

12. The integrated circuit of claim 11 wherein said at least one of said fourth and fifth source regions includes a relief area and further comprising arranging said substrate contact region in said relief area.

13. The integrated circuit of claim 11 wherein said at least one substrate contact has first and second dimensions that are less than corresponding first and second dimensions of said at least one of said fourth and fifth source regions.

14. The integrated circuit of claim 1 further comprising B source contacts arranged in each of said first, second and third source regions, where B is an integer greater than one.

15. The integrated circuit of claim 14 wherein said first and second drain contacts have an area D and said B source contacts have an area A and wherein said area D is greater than or equal to 2*B*A.

16. The integrated circuit of claim 15 where B is equal to one of 3 or 4.

## Patentansprüche

1. Integrierte Schaltung, die umfasst:
einen ersten (306-31) und einen zweiten (306-32) Drain-Bereich, die eine im Allgemeinen rechteckige Form haben;
einen ersten (304-32), einen zweiten (304-31) und einen dritten Source-Bereich, die eine im Allgemeinen rechteckige Form haben, wobei der erste Source-Bereich zwischen ersten Seiten des ersten und des zweiten Drain-Bereiches angeordnet ist und der zweite sowie der dritte Source-Bereich an zweite Seiten des ersten und des zweiten Drain-Bereiches angrenzend angeordnet sind;
einen vierten (344-3) und einen fünften (344-4) Source-Bereich, wobei der vierte Source-Bereich an dritte Seiten des ersten und des zweiten Drain-Bereiches angrenzend angeordnet ist und der fünfte Source-Bereich an vierte Seiten des ersten und des zweiten Drain-Bereiches angrenzend angeordnet ist;
einen Gate-Bereich (310), der zwischen dem ersten, dem zweiten, dem dritten, dem vierten sowie dem fünften Source-Bereich und dem ersten sowie dem zweiten Drain-Bereich angeordnet ist; und
einen ersten (334-31) und einen zweiten (334-32) Drain-Kontakt, die in dem ersten und dem zweiten Drain-Bereich angeordnet sind;
wobei der erste, der zweite und der dritte Source-Bereich von dem Gate-Bereich umgeben sind.

2. Integrierte Schaltung nach Anspruch 1, wobei der erste, der zweite und der dritte Source-Bereich eine Länge haben, die im Wesentlichen einer Länge des ersten Drain-Bereiches gleich ist, und der vierte sowie der fünfte Source-Bereich eine Länge haben, die größer ist als oder genauso groß wie eine Länge des ersten und des zweiten Drain-Bereiches.

3. Integrierte Schaltung nach Anspruch 1, wobei der erste, der zweite und der dritte Source-Bereich eine Breite haben, die geringer ist als eine Breite des ersten Drain-Bereiches.

4. Integrierte Schaltung nach Anspruch 3, wobei die Breite des ersten, des zweiten und des dritten Source-Bereiches ungefähr eine Hälfte der Breite des ersten Drain-Bereiches beträgt.

5. Integrierte Schaltung nach Anspruch 1, wobei der vierte und der fünfte Source-Bereich von Seiten derselben her angesteuert werden.

6. Integrierte Schaltung nach Anspruch 1, wobei der erste und der zweite Drain-Kontakt eine Größe haben, die größer ist als eine minimale Größe des Drain-Kontaktes.

7. Integrierte Schaltung nach Anspruch 1, wobei die Drain-Kontakte eine regelmäßige Form oder eine unregelmäßige Form haben.

8. Integrierte Schaltung nach Anspruch 1, wobei die Drain-Kontakte quadratisch, rechteckig oder kreuzförmig sind.

9. Integrierte Schaltung nach Anspruch 1, wobei der erste, der zweite und der dritte Source-Bereich Source-Kontakte enthalten.

10. Integrierte Schaltung nach Anspruch 1, wobei der erste und der zweite Drain-Bereich sowie der erste, der zweite und der dritte Source-Bereich in einer ersten Reihe angeordnet sind, und sie des Weiteren N zusätzliche Reihen umfasst, und wobei sich Drain-Bereiche wenigstens einer der N zusätzlichen Reihen den vierten oder fünften Source-Bereich teilen.

11. Integrierte Schaltung nach Anspruch 1, die des Weiteren wenigstens einen Substrat-Kontakt umfasst, der in dem vierten oder/und dem fünften Source-Bereich angeordnet ist.

12. Integrierte Schaltung nach Anspruch 11, wobei der vierte oder/und fünfte Source-Bereich eine Entlastungszone enthält/enthalten, und die Schaltung des Weiteren Anordnen des Substrat-Kontaktbereiches in der Entlastungszone umfasst.

13. Integrierte Schaltung nach Anspruch 11, wobei der wenigstens eine Substrat-Kontakt eine erste und eine zweite Abmessung hat, die kleiner sind als entsprechende erste und zweite Abmessungen des vierten oder/und fünften Source-Bereiches.

14. Integrierte Schaltung nach Anspruch 1, die des Weiteren B Source-Kontakte umfasst, die jeweils in dem ersten, dem zweiten und dem dritten Source-Bereich angeordnet sind, wobei B eine ganze Zahl größer als 1 ist.

15. Integrierte Schaltung nach Anspruch 14, wobei der erste und der zweite Drain-Kontakt eine Fläche D haben und B Source-Kontakte eine Fläche A haben und die Fläche D größer ist als oder genauso groß wie 2 x B x A.

16. Integrierte Schaltung nach Anspruch 15, wobei B gleich 3 oder 4 ist.

## Revendications

1. Circuit intégré comprenant:
des première (306-31) et seconde (306-32) régions de drain ayant une forme généralement rectangulaire;
des première (304-32), deuxième (304-31) et troisième régions de source qui ont une forme généralement rectangulaire, ladite première région de source étant disposée entre les premiers côtés desdites première et seconde régions de drain et lesdites deuxième et troisième régions de source étant disposées de manière adjacente aux seconds côtés desdites première et seconde régions de drain ;
des quatrième (344-3) et cinquième (344-4) régions de source, ladite quatrième région de source étant disposée de manière adjacente aux troisièmes côtés desdites première et seconde régions de drain et ladite cinquième région de source étant disposée de manière adjacente aux quatrièmes côtés desdites première et seconde régions de drain ;
une région de grille (310) qui est agencée entre lesdites première, deuxième, troisième, quatrième et cinquième régions de source et lesdites première et seconde régions de drain ; et
des premier (334-31) et second (334-32) contacts de drain qui sont disposés dans lesdites première et seconde régions de drain ;
dans lequel lesdites première, deuxième et troisième régions de source sont entourées par ladite région de grille.

2. Circuit intégré selon la revendication 1, dans lequel lesdites première, deuxième et troisième régions de source ont une longueur qui est sensiblement égale à une longueur de ladite première région de drain et dans lequel lesdites quatrième et cinquième régions de source ont une longueur qui est supérieure ou égale à une longueur desdites première et seconde régions de drain.

3. Circuit intégré selon la revendication 1, dans lequel lesdites première, deuxième et troisième régions de source ont une largeur qui est inférieure à une largeur de ladite première région de drain.

4. Circuit intégré selon la revendication 3, dans lequel ladite largeur desdites première, deuxième et troisième régions de source est d'environ la moitié de la largeur de ladite première région de drain.

5. Circuit intégré selon la revendication 1, dans lequel lesdites quatrième et cinquième régions de source sont commandées depuis les côtés de celles-ci.

6. Circuit intégré selon la revendication 1, dans lequel lesdits premier et second contacts de drain ont une taille qui est supérieure à une taille de contact de drain minimale.

7. Circuit intégré selon la revendication 1, dans lequel lesdits contacts de drain ont une forme régulière ou une forme irrégulière.

8. Circuit intégré selon la revendication 1, dans lequel lesdits contacts de drain ont une forme carrée, rectangulaire ou en croix.

9. Circuit intégré selon la revendication 1, dans lequel lesdites première, deuxième et troisième régions de source comprennent des contacts de source.

10. Circuit intégré selon la revendication 1, dans lequel lesdites première et seconde régions de drain et lesdites première, deuxième et troisième régions de source sont disposées dans une première rangée et comprenant en outre N rangées supplémentaires, les régions de drain d'au moins l'une desdites N rangées supplémentaires partageant l'une desdites quatrième et cinquième régions de source.

11. Circuit intégré selon la revendication 1, comprenant en outre au moins un contact de substrat disposé dans au moins l'une desdites quatrième et cinquième régions de source.

12. Circuit intégré selon la revendication 11, dans lequel ladite quatrième et/ou cinquième région de source comprend une zone en relief et comprenant en outre l'agencement de ladite région de contact de substrat dans ladite zone en relief.

13. Circuit intégré selon la revendication 11, dans lequel ledit contact de substrat présente des première et secondes dimensions qui sont inférieures aux première et seconde dimensions correspondantes de ladite quatrième et /ou cinquième région de source.

14. Circuit intégré selon la revendication 1, comprenant en outre des contacts de source B disposés dans chacune desdites première, deuxième et troisième régions de source, où B est un nombre entier supérieur à un.

15. Circuit intégré selon la revendication 14, dans lequel lesdits premier et second contacts de drain ont une zone D et lesdits contacts de source B ont une zone A et dans lequel ladite zone D est supérieure ou égale à 2*B*A.

16. Circuit intégré selon la revendication 15 où B est égal à l'un de 3 ou 4.
